Europäisches Patentamt

European Patent Office

Office européen des brevets

(19)

(11) EP 1 577 912 A1

(12) **EUROPEAN PATENT APPLICATION**
published in accordance with Art. 158(3) EPC

(43) Date of publication:
21.09.2005 Bulletin 2005/38

(21) Application number: 03768193.9

(22) Date of filing: 25.12.2003

(51) Int Cl.⁷: **H01G 4/33**, H01G 4/12

(86) International application number:
**PCT/JP2003/016654**

(87) International publication number:
**WO 2004/061881 (22.07.2004 Gazette 2004/30)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **27.12.2002 US 331140**

(71) Applicant: **TDK Corporation Tokyo 103-8272 (JP)**

(72) Inventors:
- **SAKASHITA, Yukio, TDK Corporation Tokyo 103-8272 (JP)**
- **CHOI, Kyung-ku, TDK Corporation Tokyo 103-8272 (JP)**

(74) Representative: **HOFFMANN EITLE Patent- und Rechtsanwälte Arabellastrasse 4 81925 München (DE)**

(54) **THIN FILM CAPACITOR AND METHOD FOR MANUFACTURING SAME**

(57) It is an object of the present invention to provide a thin film capacitor having a small size, large capacitance and an excellent dielectric characteristic, and a method for fabricating the thin film capacitor.

A thin film capacitor according to the present invention includes a support substrate whose surface is oriented in the [001] direction, a buffer layer which is formed on the support substrate and whose surface is oriented in the [001] direction, a lower electrode thin film which is formed on the buffer layer and whose surface is oriented in the [001] direction, a dielectric thin film containing a bismuth layer structured compound which is formed on the lower electrode thin film and whose surface is oriented in the [001] direction, namely, the c axis direction thereof and an upper electrode thin film which is formed on the dielectric thin film.

FIG. 2

EP 1 577 912 A1

# Description

## BACKGROUND OF THE INVENTION

The present invention relates to a thin film capacitor and a method for fabricating the same and, particularly, to a thin film capacitor having a small size, large capacitance and an excellent dielectric characteristic and a method for fabricating the thin film capacitor.

## DESCRIPTION OF THE PRIOR ART

Recently, the operating frequency of LSIs (Large Scale Integrated circuits), typically CPUs (Central Processing Units), has become higher and higher. In the LSI having a high operating frequency, power supply noise is very likely to be generated, and once power supply noise occurs, a voltage drop occurs due to parasitic resistance and parasitic inductance of the power supply wiring, causing the LSI to operate erroneously.

In order to prevent such a voltage drop caused by power supply noise, a decoupling capacitor is generally connected between the terminals of the LSI power supply. In the case where ea decoupling capacitor is connected between the terminals of the LSI power supply, the impedance of the power supply wiring decreases to effectively prevent voltage drop caused by power supply noise.

The impedance required of the power supply wiring is proportional to the operating voltage of the LSI and inversely proportional to the integration density of the LSI, the switching current of the LSI and the operating frequency of the LSI. Therefore, incurrent LSIs, which have high integration density, low operating voltage and high operating frequency, the impedance required of the power supply wiring is extremely low.

In order to achieve such low impedance of the power supply wiring, it is necessary to increase the capacitance of the decoupling capacitor and considerably lower the inductance of the wiring connecting the terminals of the LSI power supply and the decoupling capacitor.

As a decoupling capacitor having a large capacitance, an electrolytic capacitor or a multilayer ceramic capacitor is generally employed. However, since the size of an electrolytic capacitor or multilayer ceramic capacitor is relatively large, it is difficult to integrate it with an LSI. Therefore, the electrolytic capacitor or multilayer ceramic capacitor has to be mounted on a circuit board independently of the LSI and, as a result, the length of wiring for connecting the terminals of the LSI power supply and the decoupling capacitor is inevitably long. Accordingly, in the case where an electrolytic capacitor or a multilayer ceramic capacitor is employed as a decoupling capacitor, it is difficult to lower the inductance of the wiring for connecting the terminals of the LSI power supply and the decoupling capacitor.

In order to shorten the wiring for connecting the terminals of the LSI power supply and the decoupling capacitor, use of a thin film capacitor having a smaller size than that of an electrolytic capacitor or a multilayer ceramic capacitor is suitable.

Japanese Patent Application Laid Open No. 2001-15382 discloses a thin film capacitor having a small size and large capacitance which employs PZT, PLZT, (Ba, Sr) TiO$_3$ (BST), Ta$_2$O$_5$ or the like as a dielectric material.

However, the thin film capacitor employing any one of the above mentioned materials is disadvantageous in that the temperature characteristic thereof is poor. For example, since the dielectric constant of BST has a temperature dependency of -1000 to -4000 ppm/ °C, in the case where BST is employed as a dielectric material, the capacitance of the thin film capacitor at 80 °C varies between -6% and -24% in comparison with that at 20 °C. Therefore, a thin film capacitor employing BST as a dielectric material is not suitable for use as a decoupling capacitor for a high operating frequency LSI whose ambient temperature frequently reaches 80 °C or higher owing to heat generated by electric power consumption.

Furthermore, the dielectric constant of a dielectric thin film formed of any one of the above mentioned materials decreases as the thickness thereof decreases and the capacitance thereof greatly decreases when an electric field of 100 kV/cm, for example, is applied thereto. Therefore, in the case where any one of the above mentioned materials is used as a dielectric material for a thin film capacitor, it is difficult to simultaneously make the thin film capacitor small and the capacitance thereof great.

In addition, since the surface roughness of a dielectric thin film formed of any one of the above mentioned materials is high, its insulation performance tends to be lowered when formed thin.

It might be thought possible to overcome these problems by using a bismuth layer structured compound as a dielectric material for a thin film capacitor. The bismuth layer structured compound is discussed by Tadashi Takenaka in "Study on the particle orientation of bismuth layer structured ferroelectric ceramics and their application to piezoelectric or pyroelectric materials" Engineering Doctoral Thesis at the University of Kyoto (1984), Chapter 3, pages 23 to 36.

It is known that the bismuth layer structured compound has an anisotropic crystal structure and behaves as a ferroelectric material but that the bismuth layer structured compound exhibits only weak property as a ferroelectric material and behaves like as a paraelectric material along a certain axis of orientation.

The property of the bismuth layer structured compound as a ferroelectric material is undesirable when the bismuth layer structured compound is utilized as a dielectric material for a thin film capacitor since it causes variation in dielectric constant. Therefore, when a bismuth layer structured compound is used as a dielectric material for a thin film capacitor, it is preferable that its paraelectric property can be fully exhibited.

Therefore, a need has been felt for the development of a thin film capacitor of small size, large capacitance and excellent dielectric characteristic that has a dielectric layer in which a bismuth layer structured compound oriented in the axis of orientation along which the bismuth layer structured compound exhibits only weak property as a ferroelectric material and behaves like a paraelectric material.

## SUMMARY OF THE INVENTION

It is therefore an object of the present invention to provide a thin film capacitor having a small size, large capacitance and an excellent dielectric characteristic, and a method for fabricating the thin film capacitor.

The above object of the present invention can be accomplished by a thin film capacitor comprising a first electrode structural body, a second electrode structural body and a dielectric thin film provided between the first electrode structural body and the second electrode structural body and containing a bismuth layer structured compound, the surface of the first electrode structural body in contact with the dielectric thin film being oriented in the [001] direction.

In the present invention, the [001] direction as termed herein means the [001] direction of a cubic crystal, a tetragonal crystal, a monoclinic crystal or an orthorhombic crystal.

According to the present invention, since the surface of the first electrode structural body in contact with the dielectric thin film is oriented in the [001] direction, it is possible to improve the degree of orientation of the bismuth layer structured compound contained in the dielectric thin film in the [001] direction, namely, in the $c$ axis direction. Thus, the $c$ axis of the bismuth layer structured compound can be oriented so as to be perpendicular to the first electrode structural body and the second electrode structural body.

Therefore, when a voltage is applied between the first electrode structural body and the second electrode structural body, since the direction of the electric field substantially coincides with the c axis of the bismuth layer structured compound, the ferroelectric property of the bismuth layer structured compound can be suppressed and the paraelectric property thereof can be fully exhibited.

Further, since the dielectric layer of the dielectric material containing the bismuth layer structured compound whose c axis orientation is improved has a high insulating property, it is possible to form the dielectric layer thinner and therefore make a thin film capacitor much smaller.

Thus, since it is possible to simultaneously make the capacitance of a thin film capacitor great and the thin film capacitor small, it is possible to obtain the thin film capacitor suitable for use as a decoupling capacitor, in particular, a decoupling capacitor for an LSI having a high operating frequency.

The thin film capacitor according to the present invention is fabricated by preparing a first electrode structural body whose surface is oriented in the [001] orientation, forming a dielectric thin film containing a bismuth layer structured compound on the surface of the first electrode structural body and forming a second electrode structural body on the dielectric thin film.

In a preferred aspect of the present invention, the first electrode structural body includes an electrode thin film constituting a lower electrode of the thin film capacitor and the surface of the electrode thin film on the side of the dielectric thin film is oriented in the [001] direction.

It is not absolutely necessary for the entire surface of the electrode thin film on the side of the dielectric thin film to be oriented in the [001] direction and it is sufficient for a portion of the surface of the electrode thin film in contact with the dielectric thin film to be substantially oriented in the [001] direction among the surface of the electrode thin film of the first electrode structural body on the side of the dielectric thin film.

The first electrode structural body may be constituted only by the electrode thin film but the first electrode structural body preferably includes a support substrate and an electrode thin film which is provided on the support substrate and whose surface is oriented in the [001] direction.

The material used for forming the support substrate is not particularly limited and it is possible to form the support substrate of silicon single crystal, SiGe single crystal, GaAs single crystal, InP single crystal, $SrTiO_3$ single crystal, MgO single crystal, $LaAlO_3$ single crystal, $ZrO_2$ single crystal, $MgAl_2O_4$ single crystal, $NdGaO_3$ single crystal, $NdAlO_3$ single crystal, $LaGaO_3$ single crystal or the like. Among these, silicon single crystal is most preferable because of low cost.

The thickness of the support substrate is not particularly limited insofar as the mechanical strength of the entire thin film capacitor can be ensured and may be determined to be about 10 to 1000 $\mu m$, for example.

In the present invention, the surface of the support substrate is preferably oriented in the [001] direction.

In the present invention, the thin film capacitor preferably includes a buffer layer which is provided on the support substrate and whose surface is oriented in the [001] direction.

The buffer layer serves as a barrier layer for preventing the support substrate and the electrode thin film of the first electrode structural body from reacting with each other and also serves as a base for orienting the surface of the electrode thin film in the [001] direction.

The material used for forming the buffer layer is not particularly limited insofar as it can be oriented in the [001] direction when it is formed on the support substrate whose surface is oriented in the [001] direction and it is possible to form the buffer layer of $ZrO_2$ or $ReO_2$, $ReO_2$-$ZrO_2$, where $Re$ is yttrium (Y) or a rare earth element, MgO, $MgAl_2O_4$, $\gamma$-$Al_2O_3$, $SrTiO_3$, $LaAlO_3$ or the like.

Concretely, it is preferable to select from among these materials a material which has a small lattice mismatch with the support substrate and whose thermal expansion coefficient lies between that of the support substrate and that of the dielectric thin film and form the buffer layer of the thus selected material.

The buffer layer may have a single layer structure or a multilayer structure.

The thickness of the buffer layer is not particularly limited insofar as the buffer layer can serve as a barrier layer for preventing the support substrate and the electrode thin film of the first electrode structural body from reacting with each other and may be determined to be about 10 to 1000 nm, for example.

In the case where the buffer layer is provided, the electrode thin film is formed on the buffer layer but it is possible to form the electrode thin film on the surface of the support substrate without providing the buffer layer.

The electrode thin film of the first electrode structural body serves as one of electrodes of the thin film capacitor and also serves as a base for orienting the bismuth layer structured compound contained in the dielectric thin film in the [001] direction, namely, in the $c$ axis direction.

Therefore, the surface of the electrode thin film of the first electrode structural body has to be oriented in the [001] direction.

The material used for forming the electrode thin film of the first electrode structural body is not particularly limited insofar as it can be oriented in the [001] direction when it is formed on the support substrate or the buffer layer whose surface is oriented in the [001] direction and it is possible to form the electrode thin film of the first electrode structural body of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metal as a principal component, a conductive oxide having a perovskite structure such as $SrRuO_3$, $CaRuO_3$, $SrVO_3$, $SrCrO_3$, $SrCoO_3$, $LaNiO_3$, Nb doped $SrTiO_3$ or the like, a mixture of these, a superconductor having a superconductive layered bismuth structure such as $Bi_2Sr_2CuO_6$, or the like.

Concretely, it is preferable to select from among these materials a material having a small lattice mismatch with the support substrate or the buffer layer and form the electrode thin film of the first electrode structural body of the thus selected material.

The thickness of the electrode thin film of the first electrode structural body is not particularly limited insofar as the electrode thin film can serve as one of electrodes of the thin film capacitor and may be determined to be about 10 to 1,000 nm, for example.

In the present invention, the dielectric thin film contains a bismuth layer structured compound.

In the present invention, the dielectric thin film containing the bismuth layer structured compound may contain unavoidable impurities.

In the present invention, the bismuth layer structured compound preferably has a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$, where the symbol $m$ is a natural number, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W). In the case where the symbol $A$ and/or $B$ includes two or more elements, the ratio of the elements can be arbitrarily determined.

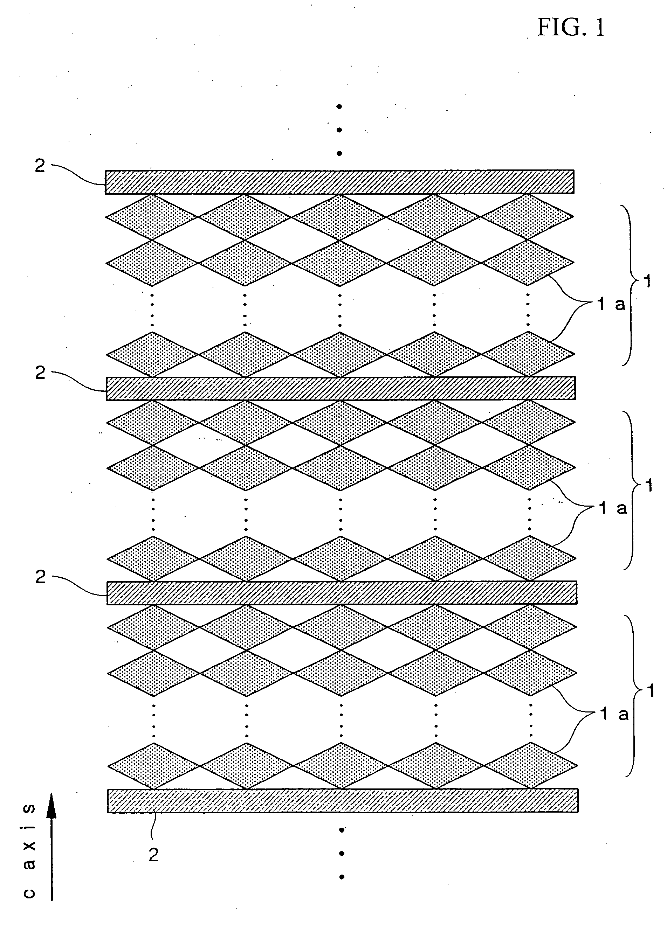

As shown in Figure 1, the bismuth layer structured compound has a layered structure formed by alternately laminating perovskite layers 1 each including perovskite lattices 1a made of (m - 1) $ABO_3$ and $(Bi_2O_2)^{2+}$ layers 2.

The number of laminates each consisting of the perovskite layer 1 and the $(Bi_2O_2)^{2+}$ layer 2 is not particularly limited and it is sufficient for the bismuth layer structured compound to include at least one pair of $(Bi_2O_2)^{2+}$ layers 2 and one perovskite layer 1 sandwiched therebetween.

In the present invention, the bismuth layer structured compound contained in the dielectric thin film is oriented in the [001] direction, namely, in the $c$ axis direction of the bismuth layer structured compound.

The $c$ axis of the bismuth layer structured compound means the direction obtained by connecting the pair of $(Bi_2O_2)^{2+}$ layers 2, namely, the [001] direction.

In the present invention, the bismuth layer structured compound contained in the dielectric thin film of the thin film capacitor is oriented in the [001] direction, namely, in the $c$ axis direction and is oriented so as to be substantially perpendicular to the first electrode structural body and the second electrode structural body. Therefore, when a voltage is applied between the first electrode structural body and the second electrode structural body, since the direction of the electric field substantially coincides with the $c$ axis of the bismuth layer structured compound contained in the dielectric thin film, the ferroelectric property of the bismuth layer structured compound can be suppressed and the paraelectric property thereof can be fully exhibited.

In the present invention, it is preferable to select a bismuth layer structured compound having an excellent characteristic as a capacitor material from among these bismuth layer structured compounds for forming the dielectric thin film.

In the present invention, the bismuth layer structured compound used for forming the dielectric thin film is not particularly limited but a bismuth layer structured compound having an excellent characteristic as a capacitor material is preferably used for forming the dielectric thin film. A bismuth layer structured compound in which the symbol *m* is equal to 4 in the general stoichiometric compositional formula thereof, in particular, that represented by the stoichiometric compositional formula: : $(Bi_2O_2)^{2+} (A_3B_4O_{13})^{2-}$ or $Bi_2A_3 B_4O_{15}$, has an excellent characteristic as a capacitor material and is preferably used as a bismuth layer structured compound for forming the dielectric thin film.

In the present invention, it is not absolutely necessary for the degree *F* of orientation in the [001] direction, namely, *c* axis orientation of a bismuth layer structured compound contained in the dielectric thin film to be 100 % but it is sufficient for the degree *F* of *c* axis orientation of the bismuth layer structured compound to be equal to or more than 80%. It is more preferable for the degree of *c* axis orientation of the bismuth layer structured compound to be equal to or more than 90% and it is much more preferable for the degree of *c* axis orientation of the bismuth layer structured compound to be equal to or more than 95%.

The degree *F* of the *c* axis orientation of the bismuth layer structured compound is defined by the following formula (1).

$$F = (P - P_0)/(1 - P_0) \times 100 \qquad (1)$$

In formula (1), $P_0$ is defined as a *c* axis orientation ratio of a bismuth layer structured compound whose orientation is completely random, namely, the ratio of the sum $\Sigma I_0 (001)$ of reflection intensities $I_o (001)$ from the surface of [001] of the bismuth layer structured compound whose orientation is completely random to the sum $\Sigma I_0 (hkl)$ of reflection intensities $I_0 (hkl)$ from the respective crystal surfaces of [*hkl*] thereof ($\Sigma I_0 (001)$ /$\Sigma I_0(hkl)$), and *P* is defined as a *c* axis orientation ratio of a bismuth layer structured compound calculated using X-ray diffraction intensity thereof, namely, the ratio of the sum $\Sigma I(001)$ of reflection intensities $I(001)$ from the surface of [001] of the bismuth layer structured compound to the sum $\Sigma I(hkl)$ of reflection intensities $I(hkl)$ from the respective crystal surfaces of [*hkl*] thereof ($\Sigma I(001)/ \Sigma I (hkl)$). The symbols *h*, *k* and *l* can each assume an arbitrary integer value equal to or larger than 0.

In the above formula (1), since $P_0$ is a known constant, when the sum $\Sigma I(001)$ of reflection intensities $I(001)$ from the surface of [001] of the bismuth layer structured compound and the sum $\Sigma I(hkl)$ of reflection intensities $I(hkl)$ from the respective crystal surfaces of [*hkl*] are equal to each other, the degree *F* of the *c* axis orientation of the bismuth layer structured compound is equal to 100 %.

The dielectric characteristic of a dielectric thin film can be markedly improved by orienting the bismuth layer structured compound in the [001] direction, namely, the *c* axis direction in this manner.

More specifically, even in the case where the thickness of the dielectric thin film of the thin film capacitor according to the present invention is equal to or thinner than, for example, 100 nm, a thin film capacitor having a relatively high dielectric constant and low loss (tan δ) can be obtained. Further, a thin film capacitor having an excellent leak characteristic; an improved breakdown voltage, an excellent temperature coefficient of the dielectric constant and an excellent surface smoothness can be obtained.

In the present invention, it is particularly preferable that the bismuth layer structured compound contained in the dielectric thin film has a composition represented by the stoichiometric compositional formula: $Ca_xSr_{(1-x)}Bi_4Ti_4O_{15}$, where *x* is equal to or larger than 0 and equal to or smaller than 1. If the bismuth layer structured compound having such a composition is used, a dielectric thin film having a relatively large dielectric constant can be obtained and the temperature characteristic thereof can be further improved.

In the present invention, parts of the elements represented by the symbols *A* or *B* in the stoichiometric compositional formula of the bismuth layer structured compound contained in the dielectric thin film are preferably replaced with at least one element *Re* (yttrium (Y) or a rare-earth element) selected from the group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

The preferable amount of replacement by the element *Re* depends upon the value of the symbol *m*. For example, in the case where the symbol *m* is equal to 3, in the compositional formula: $Bi_2A_{(2-x)}Re_xB_3O_{12}$, *x* is preferably equal to or larger than 0.4 and equal to or smaller than 1.8 and more preferably equal to or larger than 1.0 and equal to or smaller than 1.4. If the amount of replacement by the element *Re* is determined within this range, the Curie temperature (phase transition temperature from ferroelectric to paraelectric) of the dielectric layer can be controlled preferably to be equal to or higher than -100 °C and equal to or lower than 100 °C and more preferably to be equal to or higher than -50 °C and equal to or lower than 50 °C. If the Curie point is equal to or higher than -100 °C and equal to or lower than 100 °C, the dielectric constant of the dielectric thin film 6 increases. The Curie temperature can be measured by DSC (differential scanning calorimetry) or the like. If the Curie point becomes lower than room temperature (25 °C), tan δ further decreases and, as a result, the loss value *Q* further increases.

Furthermore, in the case where the symbol *m* is equal to 4, in the compositional formula : $Bi_2A_{(3-x)}Re_xB_4O_{15}$, $x$ is preferably equal to or larger than 0.01 and equal to or smaller than 2.0 and more preferably equal to or larger than 0.1 and equal to or smaller than 1.0.

Although the dielectric thin film of the thin film capacitor according to the present invention has an excellent leak characteristic even if it does not contain the element *Re,* it is possible to further improve the leak characteristic by replacing part of the elements represented by the symbols *A* or *B* with the element *Re*.

For example, even in the case where no part of the elements represented by the symbols *A* or *B* in the stoichiometric compositional formula of the bismuth layer structured compound is replaced with element *Re*, the leak current measured at the electric filed strength of 50 kV/cm can be controlled preferably to be equal to or lower than $1 \times 10^{-7}$ A/cm$^2$ and more preferably to be equal to or lower than $5 \times 10^{-8}$ A/cm$^2$ and the short circuit ratio can be controlled preferably to be equal to or lower than 10 % and more preferably to be equal to or lower than 5 %. However, in the case where parts of the elements represented by the symbols *A* or *B* in the stoichiometric compositional formula of the bismuth layer structured compound are replaced with element *Re*, the leak current measured under the same condition can be controlled preferably to be equal to or lower than $5 \times 10^{-8}$ A/cm$^2$ and more preferably to be equal to or lower than $1 \times 10^{-8}$ A/cm$^2$ and the short circuit ratio can be controlled preferably to be equal to or lower than 5 % and more preferably to be equal to or lower than 3 %.

In the present invention, the dielectric thin film can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like. Particularly, in the case where the dielectric thin film has to be formed at a low temperature, a plasma CVD process, a photo-CVD process, a laser CVD process, a photo-CSD process, a laser CSD process or the like is preferably used for forming the dielectric thin film.

In the present invention, since the surface of the first electrode structural body in contact with the dielectric thin film is oriented in the [001] direction, if the dielectric thin film containing a bismuth layer structured compound is formed on the surface of the first electrode structural body, the bismuth layer structured compound is oriented in the most thermodynamically stable direction and is thus oriented in the [001] direction, namely, in the c axis direction.

In the present invention, the thin film capacitor includes a second electrode structural body formed on the dielectric thin film and serving as the other electrode of the thin film capacitor.

The material used for forming the second electrode structural body is not particularly limited insofar as it has conductivity and the second electrode structural body can be formed of the same material as that used for forming the electrode thin film of the first electrode structural body.

Further, since it is unnecessary to consider the lattice matching characteristic of the second electrode structural body and the second electrode structural body can be formed at a room temperature, a base metal such as iron (Fe), nickel (Ni) or the like, or an alloy such as WSi, MoSi or the like can be used for forming the second electrode structural body.

The thickness of the second electrode structural body is not particularly limited insofar as the second electrode structural body can serve as the other electrode of the thin film capacitor and may be determined to be about 10 to 10,000 nm, for example.

The above object of the present invention can be also accomplished by a thin film capacitor comprising a plurality of electrode thin films whose surfaces are oriented in the [001] direction and a plurality of dielectric thin films each containing a bismuth layer structured compound, the plurality of electrode thin films and the plurality of dielectric thin films being alternately laminated.

In a preferred aspect of the present invention, even-numbered electrode thin films are short-circuit to each other and odd-numbered electrode thin films are short-circuit to each other.

The above object of the present invention can be also accomplished by a method for fabricating a thin film capacitor comprising steps of preparing a first electrode structural body whose surface is oriented in the [001] orientation, forming a dielectric thin film containing a bismuth layer structured compound on the surface of the first electrode structural body and forming a second electrode structural body on the dielectric thin film.

In a preferred aspect of the present invention, the first electrode structural body is prepared by preparing a support substrate whose surface is oriented in the [001] orientation, forming a buffer layer on the surface of the support substrate and forming an electrode thin film on the surface of the buffer layer.

In a further preferred aspect of the present invention, the buffer layer is formed on the surface of the support substrate using an epitaxial growth process.

In a further preferred aspect of the present invention, the electrode thin film is formed on the surface of the buffer layer using an epitaxial growth process, thereby orienting the surface of the electrode thin film in the [001] orientation.

In a further preferred aspect of the present invention, a dielectric thin film is formed on the surface of the electrode thin film, whereby the dielectric thin film containing a bismuth layer structured compound is formed on the surface of the first electrode structural body.

In a preferred aspect of the present invention, the dielectric thin film containing a bismuth layer structured compound is formed on the surface of the first electrode structural body using a metal organic chemical vapor deposition process (MOCVD).

The above object of the present invention can be also accomplished by a method for fabricating a thin film capacitor comprising steps of preparing a support substrate made of silicon single crystal whose surface is oriented in the [001] direction, epitaxially growing a buffer layer on the surface of the support substrate, epitaxially growing a lower electrode thin film on the surface of the buffer layer, forming a dielectric thin film containing a bismuth layer structured compound on the surface of the lower electrode thin film and forming an upper electrode thin film on the surface of the dielectric thin film.

In a preferred aspect of the present invention, the dielectric thin film containing a bismuth layer structured compound is formed on the surface of the lower electrode thin film by a MOCVD process using at least $Ca(C_{11}H_{19}O_2)_2(C_8H_{23}N_5)_2$, $Bi(CH_3)_3$ and $Ti(O-i-C_3H_7)_4$ as constituent gases.

In another preferred aspect of the present invention, the dielectric thin film containing a bismuth layer structured compound is formed on the surface of the lower electrode thin film by a MOCVD process using at least $Sr(C_{11}H_{19}O_2)_2(C_8H_{23}N_5)_2$, $Bi(CH_3)_3$ and $Ti(O-i-C_3H_7)_4$ as constituent gases.

The above and other objects and features of the present invention will become apparent from the following description made with reference to the accompanying drawings.

## BRIEF DESCRIPTION OF THE DRAWINGS

Figure 1 is a drawing schematically showing the structure of a bismuth layer structured compound.
Figure 2 is a schematic cross-sectional view showing a thin film capacitor which is a preferred embodiment of the present invention.
Figure 3 is a schematic cross-sectional view showing one example of the arrangement of thin film capacitors according to the present invention in the case where the thin film capacitors are used as decoupling capacitors.
Figure 4 is a schematic cross-sectional view showing a thin film capacitor which is another preferred embodiment of the present invention.

## DESCRIPTION OF THE PREFERRED EMBODIMENTS

Preferred embodiments of the present invention will now be described with reference to accompanying drawings.

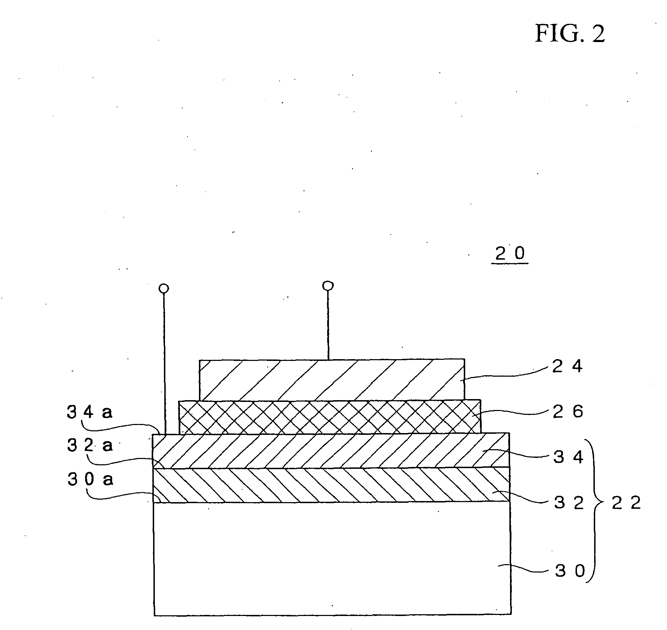

Figure 2 is schematic cross-sectional view showing a thin film capacitor which is a preferred embodiment of the present invention.

As shown in Figure 2, a thin film capacitor 20 according to this embodiment includes a lower electrode structural body 22, an upper electrode structural body 24 and a dielectric thin film 26 formed between the lower electrode structural body 22 and the upper electrode structural body 24.

The lower electrode structural body 22 includes a support substrate 30 whose surface 30a is oriented in the [001] direction, a buffer layer 32 formed on the surface 30a of the support substrate 30 and a lower electrode thin film 34 formed on the surface 32a of the buffer layer 32, and the surface 34a of the lower electrode thin film 34 is in contact with the surface of the dielectric thin film 26.

The support substrate 30 serves to ensure the mechanical strength of the entire thin film capacitor 20 and also serves as a base for orienting the surface 32a of the buffer layer 32 in the [001] direction.

The support substrate 30 is formed of silicon single crystal so as to have a thickness of about 10 to 1000 μm, for example.

The buffer layer 32 serves as a barrier layer for preventing the support substrate 30 and the lower electrode thin film 34 from reacting with each other and also serves as a base for orienting the surface of the lower electrode thin film 34 in the [001] direction.

The buffer layer 32 is formed of $ZrO_2$ or $ReO_2$, $ReO_2$-$ZrO_2$, where *Re* is yttrium (Y) or a rare earth element, MgO, $MgAl_2O_4$, $\gamma$-$Al_2O_3$, $SrTiO_3$, $LaAlO_3$ or the like, for example.

It is preferable to form the buffer layer 32 by selecting from among these materials a material which has a small lattice mismatch with the support substrate 30 and whose thermal expansion coefficient lies between that of the support substrate 30 and that of the dielectric thin film 26.

The buffer layer 32 has a thickness of about 10 to 1000 nm, for example.

The lower electrode thin film 34 serves as one of electrodes of the thin film capacitor 20 and also serves as a base for orienting the bismuth layer structured compound contained in the dielectric thin film 26 in the [001] direction, namely, the *c* axis direction thereof.

Therefore, the surface of the lower electrode thin film 34 has to be oriented in the [001] direction.

The lower electrode thin film 34 is formed of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metal as a principal component, a conductive oxide having a perovskite structure such as $SrRuO_3$, $CaRuO_3$, $SrVO_3$, $SrCrO_3$, $SrCoO_3$, $LaNiO_3$, Nb doped $SrTiO_3$ or the like, a mixture of these, a superconductor having a superconductive layered bismuth structure such as $Bi_2Sr_2CuO_6$, or the like, for example.

It is preferable to form the lower electrode thin film 34 by selecting from among these materials a material having a small lattice mismatch with the buffer layer 32.

Therefore, the buffer layer 32 has to be formed of a material having a small lattice mismatch with the support substrate 30 and the lower electrode thin film 34. For example, in the case of forming the support substrate 30 of silicon single crystal and forming the lower electrode thin film 34 of platinum (Pt), it is preferable to form the buffer layer 32 of $ZrO_2$, $ReO_2$ or $ReO_2$-$ZrO_2$, where $Re$ is yttrium (Y) or a rare earth element, MgO, $MgAl_2O_4$ or the like that has a small lattice mismatch with silicon single crystal and platinum (Pt).

The lower electrode thin film 34 has a thickness of about 10 to 1,000 nm, for example.

The dielectric thin film 26 is formed of a dielectric material containing a bismuth layer structured compound.

The bismuth layer structured compound has a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$, where the symbol $m$ is a natural number, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W). In the case where the symbol $A$ and/or $B$ includes two or more elements, the ratio of the elements can be arbitrarily determined.

The thickness of the dielectric thin film 26 depends upon the symbol $m$ in the above mentioned compositional formula and the number of the laminates each consisting of the perovskite layer 1 and the $(Bi_2O_2)^{2+}$ layer 2. For example, in the case where the symbol $m$ is equal to 4, since the lattice constant in the $c$ axis direction of the bismuth layer structured compound is about 4 nm wherein each lattice includes two perovskite layers 1 and two $(Bi_2O_2)^{2+}$ layers 3, if the number of lattices is equal to 50, the thickness of the dielectric thin film 26 is equal to about 200 nm.

The bismuth layer structured compound contained in the dielectric thin film 26 is oriented in the [001] direction, namely, the $c$ axis direction.

The thin film capacitor 20 includes the upper electrode thin film 24 formed on the dielectric thin film 26 and serving as the other electrode of the thin film capacitor 20.

The upper electrode thin film 24 can be formed of the same materials as those for forming the lower electrode thin film 34. Further, since it is unnecessary to consider the lattice matching characteristic of the upper electrode thin film 24 and the upper electrode thin film 24 can be formed at a room temperature, a base metal such as iron (Fe), nickel (Ni) or the like, or an alloy such as WSi, MoSi or the like can be used for forming the upper electrode thin film 24.

The upper electrode thin film 24 is formed so as to have a thickness of about 10 nm to 10,000 nm, for example.

The thus constituted thin film capacitor 20 is fabricated in the following manner.

A buffer layer 32 is first formed on the surface 30a of a support substrate 30 which is oriented in the [001] direction using an epitaxial growth process.

The method for forming the buffer layer 32 is not particularly limited insofar as the buffer layer 32 can be epitaxially grown and the buffer layer 32 can be formed using various thin film preparing processes such as a vacuum deposition process, a sputtering process, a pulsed laser deposition process (PLD), a chemical vapor deposition process (CVD), a chemical solution deposition process (CSD process) or the like.

The surface 32a of the buffer layer 32 epitaxially grown in this manner is oriented in the [001] direction similarly to the surface 30a of the support substrate 30.

Then, a lower electrode thin film 34 is epitaxially grown on the surface 32a of the buffer layer 32.

The method for forming the lower electrode thin film 34 is not particularly limited insofar as the lower electrode thin film 34 can be epitaxially grown.

As a result, the surface 34a of the lower electrode thin film 34 epitaxially grown in this manner is oriented in the [001] direction similarly to the surface 32a of the buffer layer 32.

A dielectric thin film 26 containing a bismuth layer structured compound is then formed on the surface 34a of the lower electrode thin film 34.

The method for forming the dielectric thin film 26 is not particularly limited and the dielectric thin film 26 can be formed using various thin film preparing processes such as a vacuum deposition process, a sputtering process, a pulsed laser deposition process (PLD), a MOCVD (Metal Organic Chemical Vapor Deposition) process, a chemical solution deposition process (CSD process) or the like.

For example, if $Ca(C_{11}H_{19}O_2)_2(CaH_{23}N_5)_2$, $Bi(CH_3)_3$ and $Ti(O\text{-}i\text{-}C_3H_7)_4$ are used as constituent gases and a bismuth layer structured compound is deposited on the surface 34a of the lower electrode thin film 34 by the MOCVD process, a dielectric thin film 26 having a composition represented by the chemical formula: $CaBi_4Ti_4O_{15}$, namely, a dielectric thin film 26 having a composition obtained by replacing the symbol m by 4, the symbol $A_3$ by $(Ca + Bi_2)$, and the symbol $B_4$ by $Ti_4$ in the compositional formula: $Bi_2A_{m-1}B_mO_{3m+3}$) is formed.

On the other hand, if $Sr(C_{11}H_{19}O_2)_2(C_8H_{23}N_5)_2$, $Bi(CH_3)_3$ and $Ti(O\text{-}i\text{-}C_3H_7)_4$ are used as constituent gases and a bismuth layer structured compound is deposited on the surface 34a of the lower electrode thin film 34 by the MOCVD process, a dielectric thin film 26 having a composition represented by the chemical formula: $Sr Bi_4Ti_4O_{15}$, namely, a dielectric thin film 26 having a composition obtained by replacing the symbol *m* by 4, the symbol $A_3$ by $(Sr + Bi_2)$, and the symbol $B_4$ by $Ti_4$ in the compositional formula: $Bi_2A_{m-1}B_mO_{3m+3}$) is formed.

When the dielectric thin film 26 containing the bismuth layer structured compound is formed on the surface 34a of the lower electrode thin film 34 oriented in the [001] direction as described above, the bismuth layer structured compound is naturally oriented in the most thermodynamically stable direction and, therefore, the bismuth layer structured compound is naturally oriented in the [001] direction, namely, the c axis direction thereof.

Then, an upper electrode thin film 24 is formed on the dielectric thin film 26.

The method for forming the upper electrode thin film 24 is not particularly limited but it is preferable to form the upper electrode thin film 24 using a sputtering process from the viewpoint of the thin film forming rate.

The foregoing completes the fabrication of the thin film capacitor 20 according to this embodiment.

According to the above described embodiment, the buffer layer 32 is epitaxially grown on the surface 30a of the support substrate 30 which is oriented in the [001] direction, thereby forming the buffer layer 32 whose surface 32a is oriented in the [001] direction and the lower electrode thin film 34 is epitaxially grown on the surface 32a of the buffer layer 32, thereby forming the lower electrode thin film 34 whose surface 34a is oriented in the [001] direction. Then, the dielectric thin film 26 containing the bismuth layer structured compound is formed on the surface 34a of the lower electrode thin film 34. Therefore, it is possible to orient the bismuth layer structured compound contained in the dielectric thin film 26b in the [001] direction, namely, the c axis direction thereof in a desired manner. Accordingly, when a voltage is applied between the lower electrode thin film 34 and the upper electrode thin film 24, since the direction of the electrical field substantially coincides with the c axis of the bismuth layer structured compound, the ferroelectric property of the bismuth layer structured compound can be suppressed and the paraelectric property thereof can be fully exhibited.

Since the thin film capacitor 20 having the above described structure has various excellent characteristics, it is possible to simultaneously make the thin film capacitor small and the capacitance thereof great by forming the dielectric thin film 26 thin, e.g., so that the thickness thereof is equal to about 1nm to 100 nm.

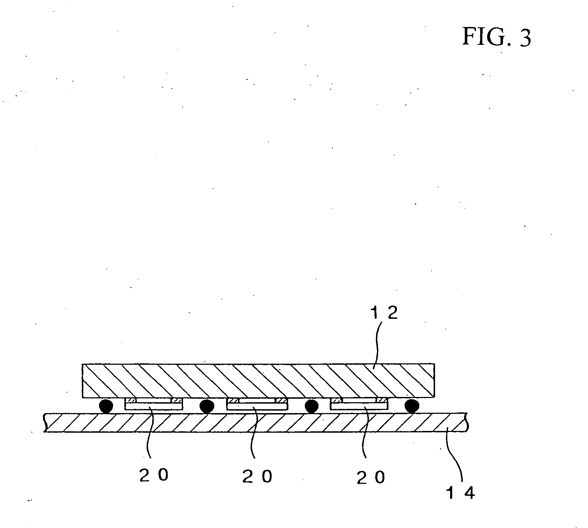

Therefore, for example, in the case where the thin film capacitor 20 is utilized as a decoupling capacitor for an LSI, the thin film capacitor 20 can be disposed between an LSI 12 and a printed circuit board 14 as shown in Figure 3 and the inductance of the wiring connecting the terminal of the power supply of the LSI 12 and the decoupling capacitor can be markedly lowered. Moreover, since the thus constituted thin film capacitor 20 has an excellent temperature characteristic, even if the temperature of the thin film capacitor 20 considerably increases owing to heating caused by electric power consumption by the LSI 12, change in the capacitance of the thin film capacitor 20 can be kept very small.

Therefore, the thin film capacitor 20 can be preferably utilized as a decoupling capacitor, in particular, a decoupling capacitor for an LSI having a high operating frequency.

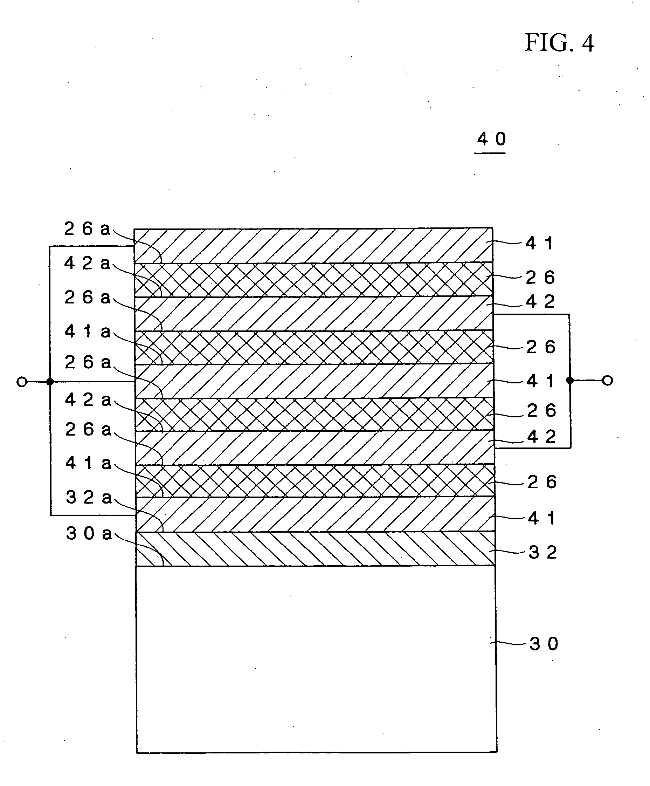

Figure 4 is a schematic cross-sectional view showing a thin film capacitor which is another preferred embodiment of the present invention.

As shown in Figure 4, a thin film capacitor 40 according to this embodiment includes a plurality of dielectric thin films 26 and first electrode thin films 41 and second electrode thin films 42 are alternately disposed between neighboring dielectric thin films 26. The first electrode thin films 41 are short-circuited and so are the second electrode thin films 42, whereby the thin film capacitor 40 can be made to have a larger capacitance than that of the thin film capacitor 20 shown in Figure 2.

As the material for forming the-first electrode thin films 41 and the second electrode thin films 42 of the thin film capacitor 40, it is necessary to employ a material which has conductivity and the surface 41a of each of the first electrode thin films 41 and the surface 42a of each of the second electrode thin films 42 can be oriented in the [001] direction when they are formed on the dielectric thin film 26, and metals such as platinum (Pt), ruthenium (Ru), rhodium (Rh), palladium (Pd), iridium (Ir), gold (Au), silver (Ag), copper (Cu), nickel (Ni) or the like, alloys containing at least one of these metals as a principal component, conductive oxides having a perovskite structure such as $SrRuO_3$, $CaRuO_3$, $SrVO_3$, $SrCrO_3$, $SrCoO_3$, $LaNiO_3$, Nb doped $SrTiO_3$ or the like, mixtures of these, superconductors having a superconductive layered bismuth structure such as $Bi_2Sr_2CuO_6$ and the like can be employed for forming the first electrode thin films 41 and the second electrode thin films 42.

It is preferable to select from among these materials a material having a very small lattice mismatch with the dielectric thin film 26 for forming the first electrode thin films 41 and the second electrode thin films 42.

However, the material for forming the uppermost electrode thin film (the first electrode thin film 41 in Figure 5) is not particularly limited insofar as it has conductivity and the uppermost electrode thin film can be formed of the same materials as those for forming the upper electrode thin film 24 of the thin film capacitor 20 shown in Figure 2. In other words, the uppermost electrode thin film can be formed of a base metal such as iron (Fe), nickel (Ni) or the like or an alloy such as WSi, MoSi or the like.

The thin film capacitor 40 having the above described structure is fabricated by epitaxially growing a buffer layer 32 on the surface 30a of a support substrate 30 which is oriented in the [001] direction to form the buffer layer 32 whose surface 32a is oriented in the [001] direction and alternately forming a first electrode thin film 41 or a second electrode thin film 42 and a dielectric thin film 26.

The first electrode thin films 41 and the second electrode thin films 42 are formed using an epitaxial growth process. As a result, the surface 41a of the first electrode thin film 41 and the surface 42a of the second electrode thin film 42 are oriented in the [001] direction in accordance with the orientation of the surface 32a of the buffer layer 32 or the surface 26a of the dielectric thin film 26 as a base. Therefore, the bismuth layer structured compound contained in the dielectric thin film 26 can be naturally oriented in the [001] direction, namely, the c axis direction thereof.

It is unnecessary to use an epitaxial growth process for forming the uppermost electrode thin film.

The present invention has thus been shown and described with reference to specific preferred embodiments. However, it should be noted that the present invention is in no way limited to the details of the described arrangements but changes and modifications may be made without departing from the scope of the appended claims.

For example, in the preferred embodiment shown in Figure 2, the lower electrode thin film 34 and the dielectric thin film 26 are in contact with each other and it is preferable to dispose the lower electrode thin film 34 and the dielectric thin film 26 so as to be in contact with each other for preventing the capacitance of the thin film capacitor 20 from being lowered. However, it is not absolutely necessary to dispose the lower electrode thin film 34 and the dielectric thin film 26 so as to be in contact with each other and another dielectric thin film whose surface on the side of the dielectric thin film 26 is oriented in the [001] direction may be interposed between the lower electrode thin film 34 and the dielectric thin film 26.

Further, in the preferred embodiment shown in Figure 4, the first electrode thin film 41 and the dielectric thin film 26 are in contact with each other and the second electrode thin film 42 and the dielectric thin film 26. are in contact with each other. It is preferable to dispose the first electrode thin film 41 and the dielectric thin film 26 so as to be in contact with each other and dispose the second electrode thin film 42 and the dielectric thin film 26 so as to be in contact with each other for preventing the capacitance of the thin film capacitor 40 from being lowered. However, it is not absolutely necessary to dispose the first electrode thin film 41 and the dielectric thin film 26 so as to be in contact with each other and dispose the second electrode thin film 42 and the dielectric thin film 26 so as to be in contact with each other and another dielectric thin film whose surface on the side of the dielectric thin film 26 is oriented in the [001] direction may be interposed between the first electrode thin film 41 and the dielectric thin film 26 and/or the second electrode thin film 42 and the dielectric thin film 26.

Furthermore, in the above described preferred embodiments, although the buffer layer 32 is formed on the surface of the support substrate 30, it is not absolutely necessary to form the buffer layer 32 on the surface of the support substrate 30 in the case where the material for forming the support substrate 30 and the material for forming the lower electrode thin film 34, or the first electrode thin film 41 or the second electrode thin film 42 do not react with each other even if they are in contact with each other and where the lattice constant of the material for forming the support substrate 30 and that of the material for forming the lower electrode thin film 34, or the first electrode thin film 41 or the second electrode thin film 42 are sufficiently close to each other.

According to the present invention, it is possible to provide a thin film capacitor having a small size, large capacitance and an excellent dielectric characteristic, and a method for fabricating the thin film capacitor.

## Claims

1. A thin film capacitor comprising a first electrode structural body, a second electrode structural body and a dielectric thin film provided between the first electrode structural body and the second electrode structural body and containing a bismuth layer structured compound, the surface of the first electrode structural body in contact with the dielectric thin film being oriented in the [001] direction.

2. A thin film capacitor in accordance with Claim 1, wherein the bismuth layer structured compound has a composition represented by the stoichiometric compositional formula: $(Bi_2O_2)^{2+} (A_{m-1}B_mO_{3m+1})^{2-}$ or $Bi_2A_{m-1}B_mO_{3m+3}$, where the symbol $m$ is a natural number, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

3. A thin film capacitor in accordance with Claim 2, wherein the symbol $m$ is an even number.

4. A thin film capacitor in accordance with Claim 1, wherein the first electrode structural body comprises a support substrate whose surface is oriented in the [001] direction and an electrode thin film which is formed on the support substrate and whose surface is oriented in the [001] direction.

**5.** A thin film capacitor in accordance with Claim 4, wherein the support substrate is formed of silicon single crystal.

**6.** A thin film capacitor in accordance with Claim 4, wherein the electrode thin film contains at least one metal selected from a group consisting of platinum (Pt), ruthenium (Ru), rhodium (Rh), palladium (Pd), iridium (Ir), gold (Au), silver (Ag), copper (Cu) and nickel (Ni).

**7.** A thin film capacitor in accordance with Claim 4, wherein the electrode thin film contains a conductive oxide having a perovskite structure.

**8.** A thin film capacitor in accordance with Claim 7, wherein the electrode thin film contains at least one conductive oxide selected from a group consisting of $SrRuO_3$, $CaRuO_3$, $SrVO_3$, $SrCrO_3$, $SrCoO_3$, $LaNiO_3$ and Nb doped $SrTiO_3$.

**9.** A thin film capacitor in accordance with Claim 4, wherein the electrode thin film contains a superconductor having superconductive layered bismuth structure.

**10.** A thin film capacitor in accordance with Claim 9, wherein the electrode thin film contains $Bi_2Sr_2CuO_6$.

**11.** A thin film capacitor in accordance with Claim 4, wherein a surface of the electrode thin film constitutes a surface in contact with a surface of the dielectric thin film of the first electrode structural body.

**12.** A thin film capacitor in accordance with Claim 4, wherein the first electrode structural body is disposed between the support substrate and the electrode thin film and further comprises a buffer layer whose surface is oriented in the [001] direction.

**13.** A thin film capacitor in accordance with Claim 12, wherein the buffer layer contains at least one oxide selected from a group consisting of $ZrO_2$, $ReO_2$, and $ReO_2$-$ZrO_2$. where $Re$ is yttrium (Y) or a rare earth element, $MgAl_2O_4$, $\gamma$-$Al_2O_3$, $SrTiO_3$ and $LaAlO_3$.

**14.** A thin film capacitor comprising a plurality of electrode thin films oriented in the [001] direction and a plurality of dielectric thin films containing a bismuth layer structured compound, the electrode thin films and the dielectric thin films being alternately layered.

**15.** A thin film capacitor in accordance with Claim 14, wherein even-numbered electrode thin films are short-circuit to each other and odd-numbered electrode thin films are short-circuit to each other.

**16.** A method for fabricating a thin film capacitor comprising steps of preparing a first electrode structural body whose surface is oriented in the [001] direction, forming a dielectric thin film containing a bismuth layer structured compound on the surface of the first electrode structural body and forming a second electrode structural body on the dielectric thin film.

**17.** A method for fabricating a thin film capacitor in accordance with Claim 16, wherein the first electrode structural body is prepared by preparing a support substrate whose surface is oriented in the [001] direction, forming a buffer layer on the surface of the support substrate and forming an electrode thin film on the surface of the buffer layer.

**18.** A method for fabricating a thin film capacitor in accordance with Claim 17, wherein the buffer layer is formed on the surface of the support substrate using an epitaxial growth process.

**19.** A method for fabricating a thin film capacitor in accordance with Claim 18, wherein the electrode thin film is formed on the surface of the buffer layer using an epitaxial growth process, thereby orienting a surface of the electrode thin film in the [001] direction.

**20.** A method for fabricating a thin film capacitor in accordance with Claim 19, wherein the dielectric thin film is formed on the surface of the electrode thin film, whereby the dielectric thin film containing a bismuth layer structured compound on the surface of the first electrode structural body.

**21.** A method for fabricating a thin film capacitor in accordance with Claim 16, wherein the dielectric thin film containing a bismuth layer structured compound is formed on the surface of the first electrode structural body using a MOCVD process.

**22.** A method for fabricating a thin film capacitor comprising steps of preparing a support substrate whose surface is oriented in the [001] direction and which is formed of silicon single crystal, forming a buffer layer on the surface of the support substrate using an epitaxial growth process, forming a lower electrode thin film on a surface of the buffer layer using an epitaxial growth process, forming a dielectric thin film containing a bismuth layer structured compound on a surface of the lower electrode thin film and forming an upper electrode thin film on the dielectric thin film.

**23.** A method for fabricating a thin film capacitor in accordance with Claim 22, wherein the bismuth layer structured compound has a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$, where the symbol $m$ is a natural number, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ includes two or more elements, the ratio of the elements is arbitrarily determined.

24. A method for fabricating a thin film capacitor in accordance with Claim 23, wherein the dielectric thin film containing the bismuth layer structured compound is formed on the surface of the electrode thin film by a MOCVD process using at least Ca $(C_{11}H_{19}O_2)_2(C_8H_{23}N_5)_2$, $Bi(CH_3)_3$ and $Ti(O\text{-}i\text{-}C_3H_7)_4$ as constituent gases.

25. A method for fabricating a thin film capacitor in accordance with Claim 23, wherein the dielectric thin film containing the bismuth layer structured compound is formed on the surface of the electrode thin film by a MOCVD process using at least Sr $(C_{11}H_{19}O_2)_2(C_8H_{23}N_5)_2$, $Bi(CH_3)_3$ and $Ti(O\text{-}i\text{-}C_3H_7)_4$ as constituent gases.

FIG. 1

FIG. 2

24
26
34a
32a
30a
34
32 } 22
30
20

FIG. 3

1 2

2 0          2 0          2 0          1 4

FIG. 4

<u>4 0</u>

## INTERNATIONAL SEARCH REPORT

| | International application No. |
|---|---|
| | PCT/JP03/16654 |

**A. CLASSIFICATION OF SUBJECT MATTER**
Int.Cl$^7$ H01G4/33, H01G4/12

According to International Patent Classification (IPC) or to both national classification and IPC

**B. FIELDS SEARCHED**

Minimum documentation searched (classification system followed by classification symbols)
Int.Cl$^7$ H01G4/33, H01G4/12

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 10-223476 A (TDK Corp.), 21 August, 1998 (21.08.98), Claims; Par. Nos. [0042] to [0043], [0054], [0077] to [0081], [0094], [0101] to [0112] (Family: none) | 1-25 |
| Y | JP 08-335672 A (Sony Corp.), 17 December, 1996 (17.12.96), Full text; all drawings & US 6151240 A1 | 1-25 |
| Y | JP 10-182291 A (Sharp Corp.), 07 July, 1998 (07.07.98), Par. Nos. [0004] to [0005], [0009], [0014] to [0016] & US 6162293 A1 & EP 849780 A | 1-25 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>06 April, 2004 (06.04.04) | Date of mailing of the international search report<br>20 April, 2004 (20.04.04) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

| International application No. |
|---|
| PCT/JP03/16654 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2000-169297 A (Sharp Corp.),<br>20 June, 2000 (20.06.00),<br>Claims; Par. Nos. [0025] to [0041]; Fig. 6<br>(Family: none) | 1-25 |
| Y | JP 07-245236 A (Rohm Co., Ltd.),<br>19 September, 1995 (19.09.95),<br>Full text; all drawings<br>& US 6052271 A1 | 1-25 |
| Y | JP 10-294432 A (Sony Corp.),<br>04 November, 1998 (04.11.98),<br>Par. Nos. [0031] to [0032]; Fig. 2<br>(Family: none) | 1-25 |
| Y | JP 08-306865 A (NEC Corp.),<br>22 November, 1996 (22.11.96),<br>Par. Nos. [0002] to [0004]; Fig. 7<br>(Family: none) | 1-25 |
| Y | JP 08-195328 A (Toshiba Corp.),<br>30 July, 1996 (30.07.96),<br>Full text; all drawings<br>(Family: none) | 1-25 |
| Y | JP 07-106198 A (Matsushita Electric Industrial Co., Ltd.),<br>21 April, 1995 (21.04.95),<br>Claims<br>& US 5459635 A1 | 15 |

Form PCT/ISA/210 (continuation of second sheet) (July 1998)